# EUROPEAN PATENT APPLICATION

(11) **EP 1 526 411 A1**
(43) Date of publication of application: **27.04.2005**
(21) Application number: 03024307.5
(22) Date of filing: 24.10.2003
(51) Int. Cl.: G03F 9/00, G03F 7/00

(54) **Apparatus and method for aligning surface**

(71) Applicant: Obducat AB, 201 25 Malmö (SE)
(72) Inventor: Montelius, Lars, 237 35 Bjärred (SE); Beck, Marc, 226 53 Lund (SE)
(74) Representative: Lindberg, Olle Nils Olof

(57) **Abstract**

Method and apparatus for aligning a first surface (11) of a first object (10) with a second surface (22) of a second object (20), facing said first surface, wherein light of a predetermined wavelength is introduced into one (10) of said objects and caused to propagate by internal reflection therein. The first and second surfaces carry correlating structures (13,25) which, when arranged at close distance from each other, couple light from said one object to the other of said objects by near-field tunnelling, to a degree dependent on the overlap of said structures. A light detector (26) is devised to detect a signal which is dependent on the amount of light coupled between said objects, for producing an alignment control signal. The invention is suitable for use in nanoimprint lithography.

## Description

### Field of the invention

The present invention relates generally to devices and methods for aligning surfaces arranged in contact with or adjacent to each other, in terms of translation and rotation in a plane parallel to said surfaces. In particular, the present invention relates to means for aligning facing surfaces of a stamp and an object in an imprint process for transferring a pattern from said stamp to said substrate.

### Background

Several techniques have been suggested for producing nanostructures, within the field of making e.g. hard drives and electronic circuits. One particular technique which has drawn a lot of attention in recent years is so-called nanoimprint lithography for producing nanostructures, i.e. structures in the order of 100 nm and smaller. This technique is described in the document US-A-5,772,905, which is incorporated herewith by reference. In the main steps of such lithography, a pattern of nanostructures is transferred from a stamp to an object. The object comprises a substrate and, applied thereto, a film of e.g. a polymer material, often called resist. After heating of the film to a suitable temperature, the stamp is pressed into the film. The stamp is then released from the object when recesses of a desired depth have been formed in layer. Thereafter, any remaining film in the recesses is removed, for instance by etching, thereby exposing the substrate. In subsequent process steps, the pattern in the film is reproduced in the substrate or in some other material which is applied to the substrate.

The film applied to the substrate is very thin, typically 50-200 nm. For even structuring of the object, the stamp and the object must thus be mutually parallel with an accuracy of a few nanometres. In industrial applications, the object can have a diameter of about 15-30 cm, which means that the surfaces contacting each other can have a maximum angle of inclination of about 10⁻⁷ rad. A greater inclination between the stamp and the object can, in addition to uneven structuring of the object, also result in the latter being smashed. In fact, the substrate is usually made of a brittle material, e.g. Si/SiO2, GaAs or InP, and the pressure exerted upon the substrate during contacting is high, typically 4-10 MPa.

A conceivable solution to the above problems would be to fix the receiving surfaces of the device in a mutually fully parallel relationship once and for all. This requires, however, that all objects have perfect plane-parallel flat sides. For reasons of manufacture, this is not possible, and therefore the device must be adjusted for each individual object. According to a previously suggested solution to this problem a plurality of power or pressure sensors are mounted in the receiving surface of the stamp or the object. A control unit is adapted to actively control the mutual angular position of the contacting means based on the thus measured pressure distribution. Another prior art solution to the problem of parallelism is proposed in SE0000848-2, describing a device having receiving surfaces for the stamp and the object, respectively, wherein the stamp and the object which are received thereon, can be put together in a non-parallel position. When the stamp is contacted with the object, they will automatically be brought into a mutually parallel position by the force acting between them pivoting one receiving surface relative to the other receiving surface.

Another problem related to the field of imprint technology, concerns aligning of parallel surfaces in the plane of said surfaces. When simply imprinting a single pattern on one side of a symmetric object, such as a circular disc, this is rarely an issue. However, imprint is often used in plural successive steps for defining different parts of a final pattern to be obtained, with intermediate steps of exposure, etching and deposition. These successive steps may e.g. be employed for defining circuit components or leads in the object. In such cases it is generally very important to orient the different layers with a near perfect match in relation to each other. In the prior art, opposing surfaces have been aligned using magnetic or capacitive methods, which requires special plates to be applied to both the stamp and the substrate. Optical solutions have also been proposed in imprint technology, such as interferometry. However, such optical means are limited by the rules of diffraction to about half a micrometer. As the development of nanoimprint lithography progresses, this resolution will be too rough.

### Summary of the invention

An object of the invention is to wholly or partly overcome the above problems of prior art, related to the issue of aligning opposing surfaces. More specifically, it is an object to provide a solution for aligning such opposing surfaces in a process for transferring a pattern from a first surface, of e.g. a stamp, to second surface, of e.g. an object. In particular, it is an object to provide a solution for aligning parallel surfaces in a plane in terms of relative translation and rotation of said surfaces.

According to a first aspect, this object is fulfilled by an apparatus for transferring a pattern from a first object having a patterned first surface, to a second object having a second surface covered by a deformable coating, by contacting said patterned first surface with said coating. The apparatus is distinguished in that:
- said objects include at least a portion made from a material which is transparent to a predetermined light wavelength and has a refractive index which causes light of said wavelength to propagate by internal reflection therein;
- a light source is devised to input light of said wavelength into one of said first and second objects;
- said first and second surfaces carry correlating structures which, when arranged at close distance from each other, couple light from said one object to the other of said objects by near-field tunnelling, to a degree dependent on the overlap of said structures;
- a light detector is devised to detect a signal which is dependent on the amount of light coupled between said objects, for producing an alignment control signal.

In one embodiment, said structures are correlated such that a maximum near-field coupling is obtainable at a predetermined translation of said surfaces in relation to each other, in a plane parallel to said surfaces.

In one embodiment, said structures are correlated such that a maximum near-field coupling is obtainable at a predetermined rotation between said surfaces in relation to each other, in a plane parallel to said surfaces.

In a first preferred embodiment, said light detector is coupled to said other of said objects.

In a second preferred embodiment, said one object comprises a first and a second portion of said material, and a light barrier between said first and second portions, each of said first and second portions carrying structures correlating with said structures of the other object, wherein input light is transferred by near-field tunnelling from said first portion to said second object and from said second objects to said second portion, said light detector being coupled to said second portion of the first object.

Preferably, said structures include raised portions from said surfaces.

In one embodiment, said structures include protruding ribs formed in said surfaces.

Advantageously, said objects are made of a semiconductor material.

In a preferred embodiment, said objects are made of silicon.

In an embodiment adapted for an imprint process, said first object is a stamp and said second object is a substrate having a resist coating.

In a preferred embodiment, said correlating structures comprises raised portions distributed over an area, with at least one lower portion between said raised portions within said are.

According to a second aspect, the object of the present invention is fulfilled by an apparatus for aligning a first surface of a first object with a second surface of a second object, facing said first surface. The apparatus is distinguished in that:
- said objects include at least a portion made from a material which is transparent to a predetermined light wavelength and has a refractive index which causes light of said wavelength to propagate by internal reflection therein;
- a light source is devised to input light of said wavelength into one of said first and second objects;
- said first and second surfaces carry correlating structures which, when arranged at close distance from each other, couple light from said one object to the other of said objects by near-field tunnelling, to a degree dependent on the overlap of said structures;
- a light detector is devised to detect a signal which is dependent on the amount of light coupled between said objects, for producing an alignment control signal.

According to a third aspect, the object of the present invention is fulfilled by a method for aligning a first surface of a first object with a second surface of a second object, facing said first surface, comprising the steps of:
- placing said surfaces in close proximity and parallel to each other;
- introducing photons into said first object, which photons are allowed to propagate by internal reflection therein;
- orienting said first and second surfaces such that correlating structures carried thereon overlap, causing light to couple from said one object to the other of said objects by near-field tunnelling, to a degree dependent on the overlap of said structures; and
- measuring a light signal which is dependent on the amount of light coupled between said objects, for producing an alignment control signal.

One embodiment of this method further comprises the step of:
- adjusting the relative position of said objects until a maximum value in said light signal is measured.

Advantageously, the method further comprises the steps of:
- adjusting the relative position of said objects to each other;
- detecting amplitude variations in said light signal; and
- adjusting the relative position of said objects to each other such that an increased value in said light signal is measured.

In one embodiment, the relative position of said objects to each other is adjusted by translation of at least one of said objects relative the other of said objects.

In one embodiment, the relative position of said objects to each other is adjusted by rotation of at least one of said objects relative the other of said objects.

### Brief description of the drawings

The invention and its advantages will be described in more detail below with reference to the accompanying schematic drawings which by way of example illustrate currently preferred embodiments of the invention. In the drawings:
Fig. 1 schematically illustrates a general setup of the orientation of opposing objects and their facing surfaces, for which alignment may be detected and controlled in accordance with the invention;
Figs 2 to 5 illustrate an imprint process with real time alignment detection and control using near-field tunnelling, according to a first embodiment of the invention;
Fig. 6 illustrates a second embodiment of the invention, using double near-field tunnelling;
Figs 7 to 13 illustrate different steps of a process for aligning opposing surfaces carrying identical alignment structures, in accordance with an embodiment of the invention;
Fig. 14 illustrates sideways light input into a stamp, according to an embodiment of the invention;
Fig. 15 illustrates backside light input into a stamp. according to another embodiment of the invention;
Fig. 16 illustrates an embodiment of a pattern for an alignment structure, usable with the present invention; and
Fig. 17 shows a schematic view of an imprint apparatus according to an embodiment of the invention.

### Detailed description of preferred embodiments

Before describing the detailed embodiments of the present invention, the principles of the invention will be considered. A major benefit of the nanoimprint technology is that ultra-fine patterns may be formed in a controlled process. When printing e.g. an integrated circuit on a substrate by use of nanoimprint lithography, different patterns are transferred to the substrate in successive steps by use of different stamps, with intermediate processing for defining conductive or insulating portions on the substrate. Alignment between the stamp and the substrate is therefore crucial. Traditional optical methods for aligning the stamp and the substrate has lower resolution than the patterned structure. However, instead of relying on or starting from known alternative methods using magnetic or capacitive alignment techniques, the present invention provides an optical solution which has been made dependent on physical structures which are smaller than the used light wavelength, thereby overcoming the limit of diffraction.

In classical optical microscopy, the spatial resolution is limited by diffraction to about half the optical wavelength λ, the Abbé limit. This limit arises because electromagnetic waves interacting with an object to be imaged are always diffracted into two components:
1) propagating waves with low spatial frequencies <2/ λ, and
2) evanescent waves with high spatial frequencies >2/ λ.

Classical optics is concerned with the far-field regime, where subwavelength features of the object to be imaged cannot be retrieved. However, by operating in the near-field regime, at a distance s typically less than λ, the Abbé limit can be surpassed. These phenomena are well known, and have been used in scanning near-field optical microscopy SNOM, providing nanometer resolution. An important feature of this technique, however, is to maintain a close distance s to the object to be monitored, since the evanescent waves are damped out rapidly. The field intensity I decreases strongly according to I ∼ s⁻⁴.

In a particular field of SNOM callad Photon Scanning Tunnelling Microscopy PSTM, a sharp optical fibre tip is used to probed the evanescent field above an object in which total internal reflection TIR is made to occur. Since every photon has a positional probability distribution, there will in each point of reflection in the object surface be a certain probability that the photon is positioned outside the surface of the object. Such photons will create an evanescent field, which is picked up by the optical fibre tip. The fibre is connected to some form of photon detector, and the surface can be scanned using e.g. a step motor. More information about near-field microscopy can be found in "Scanning probe microscopy and spectroscopy, methods and applications", Roland Wiesendanger, 1994, ISBN 0 521 418100.

The present invention makes use of the physics of near-field tunnelling from a surface, for the purpose of aligning surfaces. It should be noted that even though this description is mainly focused on the preferred embodiment and application field of nanoimprint technology, it is equally applicable within other fields where the purpose of aligning surfaces is present.

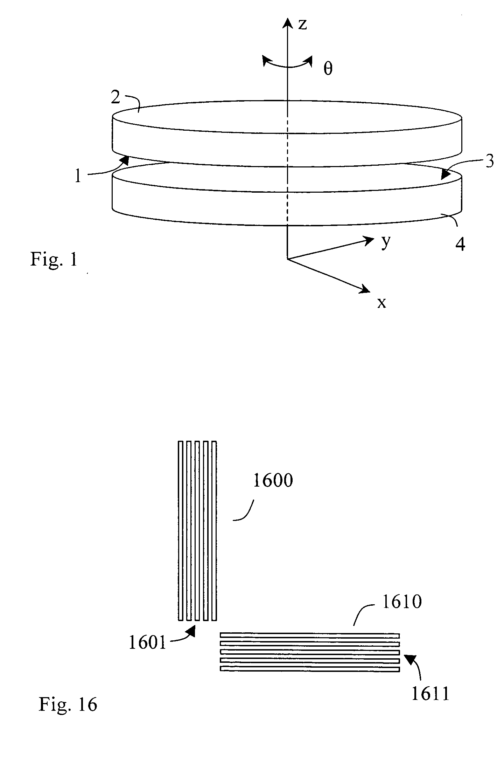

The present invention stems from the inventors' realisation that near-field tunnelling is usable for locating and controlling optimum alignment between two substantially parallel surfaces held in close proximity to each other, in terms of relative translation and rotation. Fig. 1 describes the principle outset, with a first surface 1 of an upper element 2 facing a second surface 3 of a lower element 4. Surfaces 1 and 3 are parallel to each other, perpendicular to an axis z. Elements 2 and 4 are depicted as circular in the drawing, but the invention is in no way limited to this shape. In fact, neither the two elements 2 and 4 nor the opposing surfaces 1 and 3 have to have the same shape or size. However, the object is to align at least portions of the two surfaces 1 and 3. In the embodiment of nanoimprint technology, alignment is desired between a pattern in surface 1 of a stamp 2 and a pattern in the lower element 4. According to the invention, this alignment is detected and controlled by using near-field tunnelling between the opposing surfaces 1 and 3.

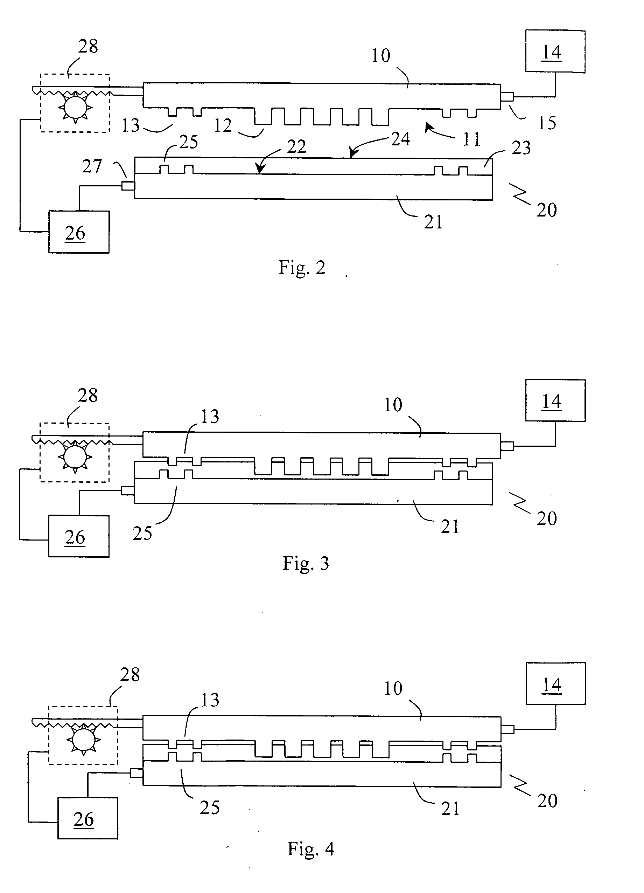

A first embodiment will now be described with reference to Figs 2 - 4.

Fig. 2 schematically shows a setup for a nanoimprint process. A stamp 10 has first surface 11 with a structured portion 12 defining a pattern. An object 20 comprises a substrate 21, which is coated on a substrate surface 22 by a deformable resist film 23 of e.g. polymethyl methacrylate, PMMA. The film 23 defines a second surface 24, which faces and is held in parallel with first surface 11.

In addition to the pattern of structured portion 12, stamp 10 is provided with an alignment structure 13 formed in surface 11. A correlating alignment structure 25 is formed in substrate surface 22. The correlating alignment structures 13, 25 are preferably identical but mirror-inverted, such that they match perfectly in a predetermined relative position of surfaces 11 and 22. However, it is not essential that they are identical, the technical effect of the invention is achievable also with different structures, when carefully chosen. Furthermore, Fig. 2 illustrates symmetric alignment structures 13 and 25, but neither this is essential. The important feature of the correlating alignment structures is that at a predetermined relative position between said alignment structures 13 and 25, there will be a maximum overlap between the alignment structures, more correctly between raised portions of the alignment structures. In Figs 2 - 4 the alignment structures 13, 25 comprises two pairs of raised portions, arranged on opposite sides of structure 12. However, it is not necessary that the alignment structures are disposed outside the pattern 12 to be imprinted, alignment structures may likewise, or additionally, be disposed between different portions of structure 12.

In this first embodiment, a light source 14 is optically connected to stamp 10, such that light of a predetermined wavelength is introduced into the body of stamp 10. Stamp 10 is therefore made from a material in which light of this wavelength can propagate. In a preferred embodiment, stamp 10 made from silicon Si. Other semiconductor materials may be used though, such as Ge, InP, GaAs etc. Furthermore, substrate 21 is preferably made from the same material as the stamp 10. One wavelength usable for an Si embodiment is 1.55 µm, which can be provided by a diode laser. The light is preferably introduced at 15 by means of an optical arrangement collimating and focusing a light beam from source 14 to a surface portion of stamp 10. In an alternative embodiment, the light source may be applied at 15 directly on the stamp 10, and even be made as a PN transition integrated with stamp 10. Once light has been entered into the body of stamp 10, it will mainly propagate by means of total internal reflection TIR, due to the large difference in refractive index between the Si stamp 10 and the surrounding atmosphere.

In Fig. 3, film 23 has been softened by means of heating and the stamp 10 has been pressed into the film 23 mainly by means of a linear movement along the z axis, see Fig. 1. In this process, raised portions of alignment structure 13 have been pressed into film 23 to close proximity with correlating raised portions of alignment structure 25. As is evidenced by the drawing in Fig. 3, the alignment between the alignment structures 13 and 25 is less than perfect. However, when there is an overlap between the raised portions of structures 13 and 25, a portion of the light which propagates with TIR in stamp 10 will tunnel over the small spacing between the raised portions of the overlapping alignment structures, and into substrate 21. A light detector 26 is optically connected to substrate 21, either by means of an optical arrangement or by direct contact at 27.

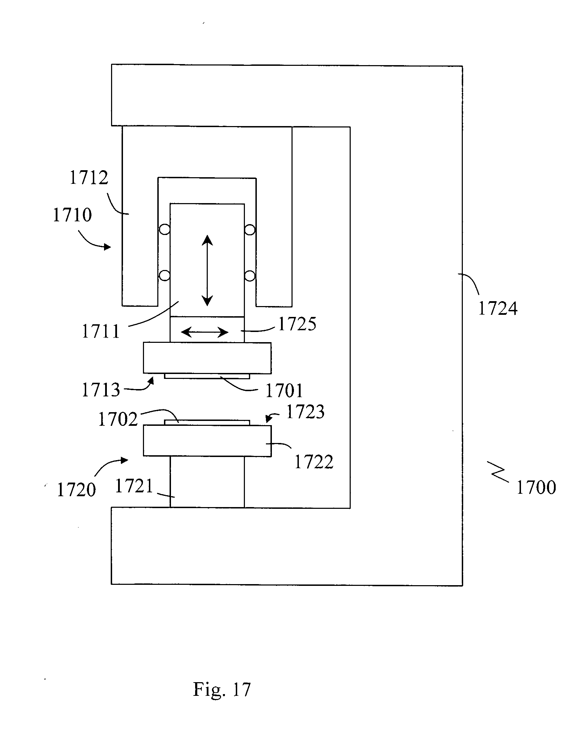

By this arrangement, a light signal can be measured by detector 26, which originates from light source 14, and which is dependent on the alignment of the stamp 10 and the object 20. More particularly, the better the alignment, the stronger the signal, since optimum alignment defines maximum overlap between the raised portions of correlating alignment structures 13, 25. This way, the relative position of stamp 10 and object 20 can be corrected online, while the film is still soft and the stamp remains pressed into the film, by relative translation and/or rotation of stamp 10 and object 20. In accordance with the invention, alignment correction means 28 is devised to displace either the object 20 or the stamp 10, or both. In the illustrated embodiment of Figs 2 to 4, means 28 include a motor device connected to stamp 10, for correcting the alignment between stamp 10 and substrate 21. The same motor may be used for displacing stamp 10 both in terms of translation and rotation, alternatively separate motors are used. The alignment correction means 28 is communicatively connected to light detector means 26, and a displacement control signal dependent on the measured signal from light detector 26 is sent to alignment correction means 28 through this connection. Furthermore, means 28 preferably includes data processing means for calculating a displacement direction dependent on the displacement control signal. It should be understood that the drawings are purely schematic, illustrating the functional details of the shown embodiment. Therefore, the cogwheel illustration in the drawings is only meant to clarify the function, and not to be seen as a design to which the invention is limited. The motor of alignment correction means 28 is in one embodiment a piezo type step motor. Furthermore, it is to be noted that said alignment correction means 28 may just as well be connected to a stamp holder, see Fig. 17, to which the stamp 10 is attached during the imprint process. In an alternative embodiment, where the alignment correction means 28 is devised to displace substrate 21, is may likewise be devised to displace a substrate holder, see Fig. 17. The mismatch shown in Fig. 3 will generate a displacement control signal to displace stamp 10 to the left in the drawing, either by purely analysing the signal from detector 26, or from a detecting the variations in the signal from detector 26 as stamp 10 is slightly moved.

In Fig. 4 the relative position of stamp 10 and object 20 has been corrected by alignment correction means 28, such that structures 13 and 25 are aligned, generating a maximum signal in the detector 26. At the relative position of Fig. 4, the film is preferably cooled, or allowed to cool, before the stamp 10 is removed by a linear movement perpendicular to and directed away from surface 22, in order for the transferred pattern to settle properly. Object 20 is thereafter ready to be processed for defining the pattern of structure 12 into surface 22 of substrate 21, according to well known methods.

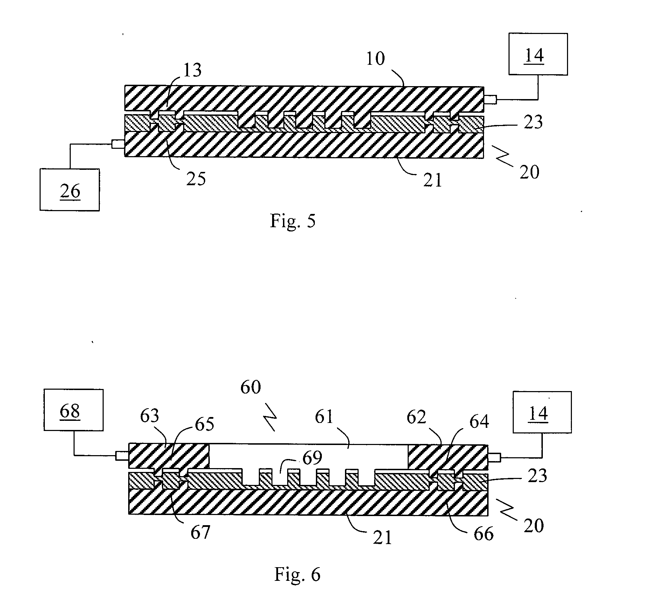

Fig. 5 shows a drawing corresponding to Fig. 4, without showing the alignment correction means. However, in this drawing the body of the stamp 10 and the substrate 21 have been dashed, indicating that they are made from the same material, e.g. Si, or different materials having similar refraction properties. The evanescent waves in the near-field will cause light to tunnel over the small gap between the raised portions of alignment structures 13, 25 through the film 23. The gap is > 0 and preferably less than 50 nm, advantageously less than 10 nm. It is preferred that the material of stamp 10 and substrate 21 is the same. If not so, their refractive indexes should at least match in order for successful tunnelling to be achieved.

Fig. 6 illustrates a second embodiment of the invention, in which a modified stamp 60 is employed. Otherwise, the imprint setup in Fig. 6 is depicted in the same state as in Fig. 5, i.e. with stamp 60 pressed into film 23. In the illustrated embodiment of Fig. 6, stamp 60 comprises at least two portions 62 and 63, and a light barrier 61. First portion 62 carries a first alignment structure 64 of the stamp, which correlates with a first alignment structure 66 of the substrate 21. Furthermore, a second stamp portion 63 carries a second alignment structure 65 of the stamp, which correlates with a second alignment structure 67 of the substrate 21. A light source 14 is optically connected to stamp 60, such that light of a predetermined wavelength is introduced into the first portion 62 of stamp 60. A light detector 68 is optically connected to second portion 63 of stamp 60. At least one light barrier 61 is optically placed between said first 62 and second 63 stamp portions, such that light introduced from source 14 into first portion 62 will not propagate directly into second portion 63.

In this embodiment, both light source 14 and light detector 68 are connected to stamp 60. Light entered into first portion 62 from light source 14 tunnels through film 23 to substrate 21, over alignment structures 64 and 66. Tunnelled light continues to propagate by TIR inside substrate 21, and tunnels over alignment structures 67 and 65 to the second stamp portion 63, where a light signal is detected by light detector 68. The same effect is consequently achieved as in the previously described embodiment of Figs 2 to 5, namely that a light signal can be measured by detector 68, which is dependent on the alignment of stamp 60 and substrate 21. Furthermore, an alignment control signal dependent on the light signal measured by light detector 68 is usable for controlling alignment correction means (not shown), which comprises means for displacing stamp 60 or substrate 21, or both, in the manner as described for the previous embodiment with reference to Figs 2 to 4. As only one stamp is manufactured for use with plural objects for mass production of patterned substrates, this embodiment of Fig. 6 saves time and effort for setting up the process of imprinting each individual substrate, since no light coupling to substrate 21 needs to be connected.

In the disclosed embodiment of Fig. 6, the light barrier constitutes a third portion 61 of stamp 60, which also carries the patterned structure 69 to be transferred to object 20. A benefit of such an embodiment is that there will be no light coupling between structure 69 and the surface of substrate 21, thereby reducing background noise when detecting the light output. However, care should be taken in selecting material for light barrier 61, to avoid heat expansion which deviates too much from the material of the substrate 21, given the accuracy requirements of the applicable imprint process. In an alternative embodiment, light barrier 61 is achieved by introducing a doped region in a Si stamp, such as at the borders between the portions 61, 62 and 61, 63, respectively, in Fig. 6, which will act as a mirror for the selected wavelength.

In accordance with the invention, it is preferred that the alignment structures are designed such that once a certain coupled light signal is detected by the light detector, it should in some way be conceivable in which direction correction of translation and/or rotation must be made to achieve optimum alignment. The best solution would be to have an alignment structure which provides a constantly increasing coupling, i.e. overlap of raised portions, when correct alignment is approached. A small adjustment from the instant position as illustrated in Fig. 3 will then reveal in which way the translation is to be made, by detecting the signal from detector 26. An alternative solution is to have provide alignment structures which generate an oscillating signal dependent on the translation, but where the signal amplitude reaches a maximum value at the correct relative position of the surfaces. By translating the surfaces over plural peaks of the oscillating signal, the placement of the correct peak could then even be calculated by means of statistical methods, which may be used to translate the stamp 10 or object 20.

The magnitude of the output signal, i.e. the signal measured be detector 26 or 68, is dependent on the amount of tunnelled light. Due to the strong dependency of the distance between the surfaces, the amount of tunnelled light is almost entirely dependent on the size of the overlapping region of the raised portions, at which the upper surfaces of the raised portions will couple light by near-field tunnelling from the stamp to the substrate, or vice versa. The simplest possible pattern of the alignment structures is a single raised element in each of surfaces 11 and 23. When the structures are perfectly aligned, a maximum signal is obtained, and in all other relative positions the signal, i.e. the overlap, will increase as the alignment is improved.

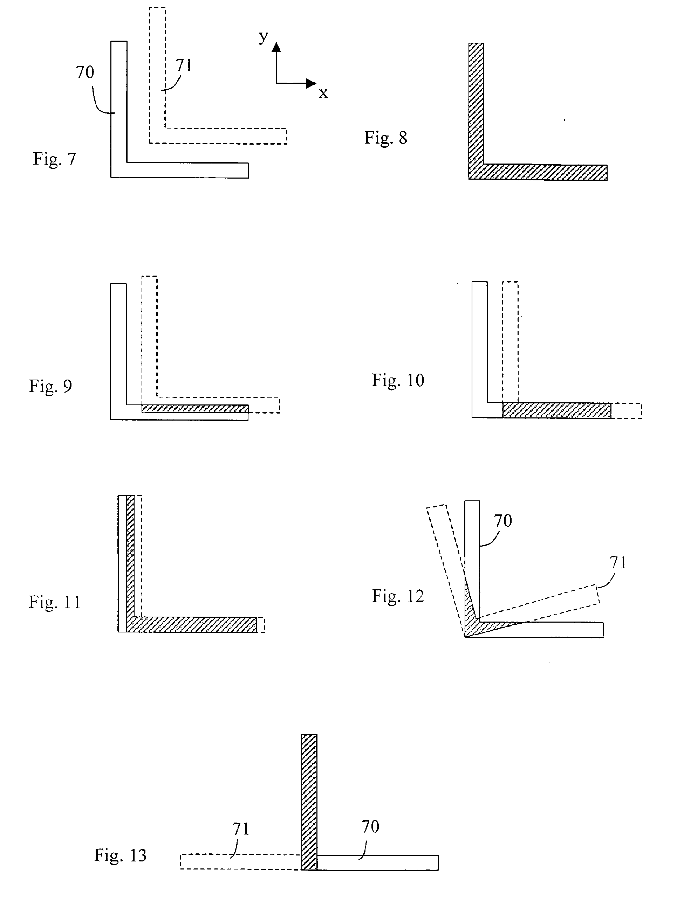

Figs 7 to 13 illustrate one embodiment of a simple alignment structure patterns, constituting an L shape. An L shape is an improvement compared to a simple straight rib, since it will provide a relatively large overlap in both the x and y direction in the plane of the facing surfaces of the stamp and the substrate. Structure 70 represents the alignment structure in the stamp, corresponding to 13 in the first embodiment and to 64 or 65 in the second embodiment described above. In turn, structure 71 represents the alignment structure in the substrate, corresponding to 25 in the first embodiment and to 66 or 67 in the second embodiment described above. Fig. 7 illustrates completely separated structures 70 and 71, generating no near-field coupling, whereas Fig. 8 illustrates perfect alignment, the dashed portions in Figs 7 to 13 illustrating the overlap.

Moving structure 71 downwards from the position in Fig. 7 eventually results in a partial overlap, as illustrated in Fig. 9, which will yield a signal corresponding to the size of the overlap. Once the signal representing this overlap is detected, displacement of structure 71 will result in a variation in the detected signal. Data processing means are preferably employed for controlling the motion of structure 71, i.e. the relative position of the stamp and the substrate, dependent on the variations in the signal, such that structure 71 is moved to a position as depicted in Fig. 10 with perfect vertical matching. Any movement in the vertical direction, i.e. along the y axis, from the position in Fig. 10 will result in a decreased overlap and signal. Subsequently displacing structure 71 horizontally, i.e. in the x direction, from the position in Fig. 10 will eventually lead to the vertical bars of the structures to partially overlap, as shown in Fig. 11. From this position, further displacement control progresses in the same manner in the horizontal direction until full overlap according to Fig. 8 is achieved. The same result can of course be achieved by first correcting in the horizontal direction, and thereafter in. the vertical direction.

The example above described with reference to Figs 7 to 11 shows a simplified case, where translation is made exactly parallel with the respective legs of the structures. However, this may not always be the case, and a combination of translation in two perpendicular directions will then have to be made in order to create a movement parallel with a leg of the structure. This is a simple rotational translation of coordinate systems, though, which can be taken care of by computer processing means of the alignment correction means.

Fig. 12 illustrates a mismatch in rotation between alignment structures 70 and 71. From this position it will be appreciated that clockwise rotation of structure 71 will lead to an increased signal, and eventually to full overlap according to Fig. 8. However, extreme counter-clockwise rotation will lead to matching of one of the legs of the L shaped structures, but not the other, as illustrated in Fig. 13. For this reason, it is advantageous to have both rough and fine alignment of the stamp relative to the substrate. Aligning in steps of 90° is hardly a problem, and can easily be performed with a fraction of a degree accuracy with a number of known methods. After this rough alignment, fine alignment is preferably performed according to the process of Figs 7 to 12.

An alternative design to the L shape, basically having the same effect, is to provide two single ribs in straight angles, like a disrupted L shape. The two perpendicular ribs may also be disposed at completely different portions of the surfaces.

As mentioned, the alignment structures may disposed anywhere on the facing surfaces. However, in terms of rotational correction it is advantageous to dispose alignment structures on at least two spaced apart surface portions, as indicated in Figs 2 to 6.

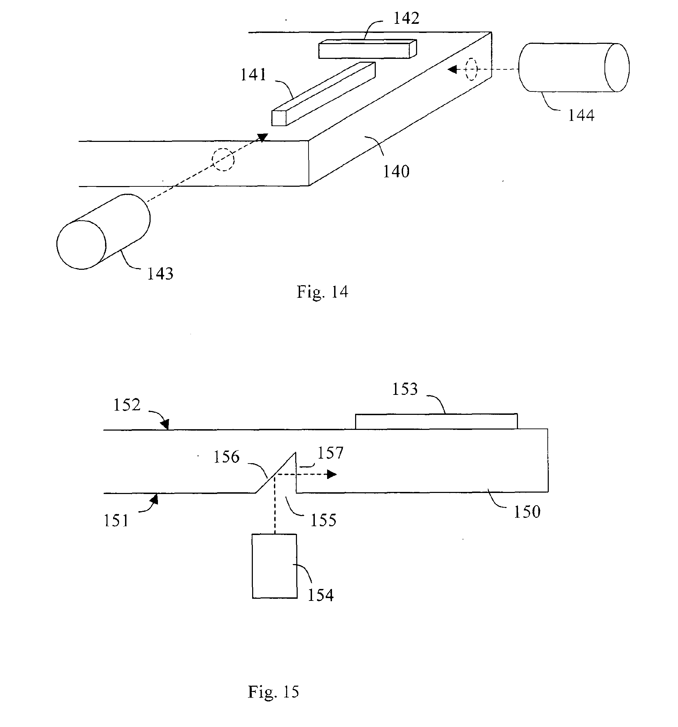

Another feature which is applicable to the present invention, is to actively direct light towards the alignment structures, in order to increase the signal to noise ratio. Even though light will propagate with TIR in the body into which light is first introduced from the light source, i.e. the stamp in the disclosed embodiments, the intensity at the alignment structure may be increased by directly concentrating the light towards that area. Fig. 14 discloses an embodiment of a stamp 140 with an alignment structure comprising comprises a first elongated rib 141 extending in a first direction and a second elongated rib 142 extending in a second direction, which is different from and preferably perpendicular to the first direction. It is advantageous to direct the introduced light in the same direction as the elongation of the ribs, since more photons will in fact hit the upper surface of the raised rib portion. For this reason, light is introduced at different portions of the side of the stamp, parallel to and at least roughly aligned with the ribs of the structure. A first light source 143 emits light parallel to first rib 141, whereas second light source 144 emits light parallel to second rib 142. An optical arrangement, included in light sources 143 and 144, comprising lenses and/or mirrors is preferably used to shape the beam of light from the light sources, and an aperture may be used to narrow the beam. Both light sources 143, 144 may be operated simultaneously. In an alternative embodiment, though, the light sources 143 and 144 are operated one at a time, wherein alignment in the x and y directions may be performed separately. Alignment structures 141 and 142 may of course also be connected in an L shape as in Fig. 7.

Fig. 15 schematically illustrates an alternative way of introducing light into a stamp 150. Instead of coupling light to the side of the stamp, it is introduced through surface 151 opposite surface 152 carrying alignment structures 153 and the patterned structure to be transferred (not shown). In this drawing only one alignment structure is shown, though obviously the same arrangement may be applied in a direction within the plane of surface 152 which is perpendicular to alignment structure 153. An optical arrangement 154 comprises a light source and means for directing and shaping the beam, comprising lenses and/or mirrors and possibly an aperture for narrowing the beam. The light beam is directed to a recessed portion 155 in surface 151. The recessed portion comprises an angled surface 156 which acts as a mirror for the light. The angled portion may be coated with a suitable material for this purpose. Light impinging on the angled mirror surface 156 is directed to a substantially vertical coupling surface 157, through which light enters into the body of stamp 150, as is illustrated by the dashed line representing an optical axis along which light propagates. The direction and angle of recessed portion 155 is selected such that input light is directed towards and parallel to alignment structure 153. In one embodiment, angled surface 156 is tilted about 45° from surface 151, resulting in a substantially horizontal direction of propagation in stamp 150 when light is directed perpendicular to surface 151 from light source 154. However, it should be noted that differently angled recesses 155 may be employed, both regarding the vertical angle and the direction within the plane of stamp 150, such that light directed perpendicular, or at any other predetermined angle to surface 151, is directed by angled surfaces 156 to selected portions of surface 152 carrying alignment structures 153, and parallel to those alignment structures.

Fig. 16 illustrates an embodiment of an alignment structure according to the invention. Basic perpendicular portions 1600 and 1610, corresponding to alignment structures 141 and 142 shown in Fig. 14, extend in the plane of the stamp surface. However, each portion comprises a finer pattern, in the displayed embodiment in the shape of ribs parallel to the extension direction of the alignment structure portion in which they are included. Alignment structure portions 1600 and 1610 may be identical, apart from the angle, or different. In the shown embodiment of Fig. 16 they are identical, and only the first alignment structure portion 1600 will therefore be described in more detail. Alignment structure portion 1600 comprises five parallel ribs 1601. The width of each rib is preferably less than 100 nm, advantageously less than 10 nm. The spacing between each to adjacent fine ribs 1601 may be the same as the width of ribs 1601, but may also be smaller or larger. Furthermore, all ribs 1601 in portion 1600 may be identical, but they may also have different widths and be disposed with different spacing to the adjacent rib 1601. A design, such as that shown in the drawing, with an larger pattern structure 1600 and 1610, and a finer pattern 1601 and 1611 within the larger pattern structure, makes it easier to optimise the alignment. With any overlap with an identical pattern of an opposing surface of e.g. a substrate, there will generally be some degree of tunnelling between the opposing surfaces. Fine tuning of the alignment can then proceed by detecting the varying throughput dependent on the matching of the finer structures of ribs 1601 and 1611 with corresponding structures of the opposing surface. Since the light coupled by tunnelling in the near-field may be of low intensity, it will often be appropriate to have alignment structures with a certain minimum total area of the raised portions in order to generate a sufficient signal, whereas the fine structure of the raised portions guarantees that the overlap, and therefore the amount of tunnelled light, varies strongly even with small relative displacement of the surfaces.

Fig. 17 is a schematic view of an apparatus 1700 according to an embodiment of the invention. The apparatus, which is intended to transfer a pattern from a stamp 1701 to an object 1702, comprises a press 1710 and an abutment 1720 coacting with the press. The press 1710, which can be of a prior-art type, such as a hydraulically operated press, has a piston element 1711 which is movable back and forth in a well-defined direction relative to a fixedly arranged body 1712 of press 1710. The piston element 1711 has on its side facing away from body 1712 a surface 1713 for receiving the stamp 1701. Abutment 1720 comprises a base 1721 and a holder 1722, which on its side facing away from the base 1721 has a surface 1723 for receiving the object 1702. The surface 1723 is of essentially the same extent as the object 1702 to be received thereon. A locking means (not shown) for securing the object 1702 is arranged at the surface 1723. This locking means can of an arbitrary kind, but for automatic production it is preferable to use subatmospheric pressure in this securing of the object. Body 1712 of press 1710 and base 1721 of abutment 1720 are supported by a chassis 1724.

In accordance with the invention, means 1725 for adjusting the relative position of stamp 1701 and object 1702 in a plane of the facing surfaces of stamp 1701 and object 1702, perpendicular to the press direction of piston 1711, are further provided. In the shown embodiment, means 1725 are preferably arranged in connection with the stamp holder surface 1713, but may alternatively be devised at holder 1722 for object 1702.

Fig. 17 displays an overview of an embodiment in which the invention related to alignment detection and control is employed, whereas the function and operation of means 1725, using near-field tunnelling over alignment structures in the stamp 1701 and object 1702, is more thoroughly described above with reference to Figs 2 to 16. The present invention is not limited to the field of nanoimprint lithography, but is particularly suitable for use in such processes, since it provides optical means for detecting and controlling alignment of ultra-fine nanometer structures, using light of a wavelength which is several times larger than those structures.

## Claims

1. Apparatus for transferring a pattern from a first object (10) having a patterned first surface (11), to a second object (20) having a second surface (22) covered by a deformable coating (23), by contacting said patterned first surface with said coating, **characterised in that**:
- said objects include at least a portion made from a material which is transparent to a predetermined light wavelength and has a refractive index which causes light of said wavelength to propagate by internal reflection therein;
- a light source (14) is devised to input light of said wavelength into one (10) of said first and second objects;
- said first and second surfaces carry correlating structures (13,25) which, when arranged at close distance from each other, couple light from said one object to the other of said objects by near-field tunnelling, to a degree dependent on the overlap of said structures;
- a light detector (26) is devised to detect a signal which is dependent on the amount of light coupled between said objects, for producing an alignment control signal.

2. The apparatus as recited in claim 1, **characterised in that** said structures are correlated such that a maximum near-field coupling is obtainable at a predetermined translation of said surfaces in relation to each other, in a plane parallel to said surfaces.

3. The apparatus as recited in claim 1, **characterised in that** said structures are correlated such that a maximum near-field coupling is obtainable at a predetermined rotation between said surfaces in relation to each other, in a plane parallel to said surfaces.

4. The apparatus as recited in claim 1, **characterised in that** said light detector is coupled to said other (20) of said objects.

5. The apparatus as recited in claim 1, **characterised in that** said one object (60) comprises a first (62) and a second (63) portion of said material, and a light barrier (61) between said first and second portions, each of said first and second portions carrying structures (64,65) correlating with said structures (66,67) of the other object (20), wherein input light is transferred by near-field tunnelling from said first portion to said second object and from said second objects to said second portion, said light detector (68) being coupled to said second portion of the first object.

6. The apparatus as recited in claim 1, **characterised in that** said structures include raised portions from said surfaces.

7. The apparatus as recited in claim 1, **characterised in that** said structures include protruding ribs formed in said surfaces.

8. The apparatus as recited in claim 1, **characterised in that** said objects are made of a semiconductor material.

9. The apparatus as recited in claim 9, **characterised in that** said objects are made of silicon.

10. The apparatus as recited in claim 1, **characterised in that** said first object is a stamp and said second object is a substrate having a resist coating.

11. The apparatus as recited in claim 1, **characterised in that** said correlating structures comprises raised portions (1601) distributed over an area (1600), with at least one lower portion between said raised portions within said are.

12. Apparatus for aligning a first surface (11) of a first object (10) with a second surface (22) of a second object (20), facing said first surface, **characterised in that**:
- said objects include at least a portion made from a material which is transparent to a predetermined light wavelength and has a refractive index which causes light of said wavelength to propagate by internal reflection therein;
- a light source (14) is devised to input light of said wavelength into one (10) of said first and second objects;
- said first and second surfaces carry correlating structures (13,25) which, when arranged at close distance from each other, couple light from said one object to the other of said objects by near-field tunnelling, to a degree dependent on the overlap of said structures;
- a light detector (26) is devised to detect a signal which is dependent on the amount of light coupled between said objects, for producing an alignment control signal.

13. Method for aligning a first surface (11) of a first object (10) with a second surface (22) of a second object (20), facing said first surface, comprising the steps of:
- placing said surfaces in close proximity and parallel to each other;
- introducing photons into said first object, which photons are allowed to propagate by internal reflection therein;
- orienting said first and second surfaces such that correlating structures (13,25) carried thereon overlap, causing light to couple from said one object to the other of said objects by near-field tunnelling, to a degree dependent on the overlap of said structures; and
- measuring a light signal which is dependent on the amount of light coupled between said objects, for producing an alignment control signal.

14. The method as recited in claim 13, further comprising the step of:
- adjusting the relative position of said objects until a maximum value in said light signal is measured.

15. The method as recited in claim 13, further comprising the steps of:
- adjusting the relative position of said objects to each other;
- detecting amplitude variations in said light signal; and
- adjusting the relative position of said objects to each other such that an increased value in said light signal is measured.

16. The method as recited in claim 14 or 15, wherein the relative position of said objects to each other is adjusted by translation of at least one of said objects relative the other of said objects.

17. The method as recited in claim 14 or 15, wherein the relative position of said objects to each other is adjusted by rotation of at least one of said objects relative the other of said objects.
